(19) Europäisches Patentamt
European Patent Office
Office européen des brevets

(11) Numéro de publication : **0 312 427 B1**

# (12) FASCICULE DE BREVET EUROPEEN

(45) Date de publication du fascicule du brevet : **17.07.91 Bulletin 91/29**

(51) Int. Cl.$^5$ : **G01R 33/56**

(21) Numéro de dépôt : **88402523.0**

(22) Date de dépôt : **05.10.88**

## (54) Procédé d'imagerie de mouvements intravoxels par RMN dans un corps.

(30) Priorité : **13.10.87 FR 8714098**

(43) Date de publication de la demande : **19.04.89 Bulletin 89/16**

(45) Mention de la délivrance du brevet : **17.07.91 Bulletin 91/29**

(84) Etats contractants désignés : **DE ES GB IT NL**

(56) Documents cités :
**EP-A- 0 208 601**
**EP-A- 0 213 436**
**EP-A- 0 216 490**
**EP-A- 0 216 657**

(56) Documents cités :
**MAGNETIC RESONANCE IMAGING, tome 1, 1982, pages 197-203, P.R. MORAN et al.: "A Flow Velocity Zeugmatorgrafphic Interlace for NMR Imaging in Humans".**

(73) Titulaire : **GENERAL ELECTRIC CGR S.A.
13, Square Max-Hymans
F-75015 Paris (FR)**

(72) Inventeur : **Le Bihan, Denis
Cabinet Ballot-Schmit 84, Avenue Kléber
F-75116 Paris (FR)**

(74) Mandataire : **Schmit, Christian Norbert Marie et al
Cabinet Ballot-Schmit 7, rue Le Sueur
F-75116 Paris (FR)**

EP 0 312 427 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet un procédé d'imagerie des mouvements intravoxels par résonance magnétique nucléaire (RMN) dans un corps. Elle trouve son application plus particulièrement dans le domaine médical où l'imagerie RMN procure une aide indipensable au diagnostic.

On connait par la demande de brevet européen n° 86 401 423.8 (EP-A-208 601) un procédé d'imagerie par RMN. Dans ce procédé, on a expliqué que la représentation des images classiques, par mise en évidence des temps de relaxation $T_1$ spin-réseau et $T_2$ spin-spin des moments magnétiques des particules d'un corps sous examen n'est pas toujours suffisante pour permettre de différencier certains tissus sains de tumeurs avoisinantes et pour permettre d'identifier des lesions. Pour améliorer cette différenciation il a été proposé d'effectuer une mesure, et une représentation, de la distribution des coefficients de diffusion moléculaire des particules des tissus imagés. Dans la mise au point de cette invention il est apparu que la méthode de revélation des coefficients de diffusion moléculaire ne permettait pas de faire abstraction de mouvements moléculaires plus globaux à l'intérieur des éléments de volume pris en compte et correspondant à la discrétisation nécessaire d'une image pour permettre le calcul de cette image. Ces éléments de volume sont appelés les voxels. En effet des mouvements d'ensemble, par exemple des molécules du sang, créent des microcirculations qui viennent se confondre avec les caractéristiques de diffusion moléculaire des tissus étudiés.

Dans la demande de brevet précitée on a montré qu'en réitérant une expérimentation d'imagerie, avec des caractéristiques d'expérimentation différentes, et en comparant les résultats obtenus à l'issue de la première expérimentation à ceux obtenus à l'issue de la deuxième expérimentation on pouvait être capable de présenter deux images. Avec ces deux images les coefficients de diffusion moléculaire pouvaient être présentés indépendamment de coefficients de perfusion sanguine des tissus et vice versa.

Dans la pratique la première expérimentation comporte deux séries d'excitations radiofréquences du corps soumis à l'examen de RMN : une première série dite peu diffusante et une deuxième série dite diffusante. La deuxième expérimentation ne comporte qu'une troisième série d'excitations radiofréquences dite également diffusantes, mais avec des caractéristiques de sensibilisation à la diffusion moléculaire différente des caractéristiques de sensibilisation à la diffusion moléculaire de la deuxième série d'excitations. En effet dans la deuxième expérimentation il est inutile de réitérer la série des excitations peu diffusantes. Une série d'excitations radiofréquences comporte plus précisément une série de séquences d'excitation-mesure. Dans chaque séquence, le corps à examiner est soumis à une excitation à l'issue de laquelle le signal de RMN résultant de cette excitation est mesuré. Au cours de l'excitation des codages magnétiques de l'espace sont de plus appliqués au corps, de manière à provoquer des codages du signal mesuré afin d'en extraire, par décodage, des informations directement représentatives de valeurs de luminosité à attribuer aux différents éléments d'image (pixel) de l'image. Ces codages-décodages constituent des méthodes d'imagerie. Ces codages sont appliqués sous la forme d'impulsions de gradient de champ magnétique. Une méthode préférée d'imagerie décrite dans la demande de brevet précitée est la méthode 2DFT. La caractéristique essentielle de l'invention ayant fait l'objet de la demande de brevet précitée réside dans une durée commune de toutes les séquences de toutes les séries de séquences des expérimentations.

Dans les séquences d'excitation-mesure, le signal de RMN résultant de l'excitation est connu pour s'évanouir très rapidement après l'excitation, c'est-à-dire avant que des codages magnétiques supplémentaires ne puissent être efficacement appliqués dans les régions à imager, préalablement à la mesure. Cet évanouissement est dû aux inhomogénéités du champ magnétique orientateur dans le corps examiné. Ces inhomogénéités provoquent une dispersion correspondante de la phase des signaux de RMN émis par les différentes particules distribuées dans l'espace. On a pris l'habitude de provoquer la réflexion de cette dispersion de phase en appliquant une impulsion supplémentaire d'excitation dite impulsion d'écho de spin, où encore impulsion à 180° parce qu'elle a pour effet de faire basculer de 180° l'orientation des moments magnétiques des particules à imager. Au bout d'une durée double de celle qui sépare l'excitation de l'application de cette impulsion d'excitation à 180°, le signal de RMN renaît et peu être mesuré. Typiquement chaque séquence d'excitation-mesure d'un tel type est séparée de la suivante par 400 à 1000 millisecondes (temps de répétition).

La définition des images présentée est d'autant plus précise que le nombre des séquences d'excitation-mesure de chaque série d'excitations est important. En definitive les images déterminées à l'issue de chaque série sont d'autant plus précises que leur acquisition a duré plus longtemps. Comme il est nécessaire d'acquérir trois séries d'excitations, la durée totale pendant laquelle un patient est soumis à un tel examen de RMN peut être rédhibitoire. On rencontre, en agissant ainsi, des durées d'examen de l'ordre de 20 minutes. D'une manière générale, pour résoudre les problèmes liés aux durées des expérimentations, on a maintenant recours à une technique d'excitation dite excitation des moments magnétiques en régime d'équilibre dynamique, en littérature anglo-saxonne SSFP (STEADY STATE FREE PRECESSION). Selon cette technique les excitations sont très proches dans le temps les unes des autres et font basculer, à chaque fois, les moments magnétiques des molécules du corps d'un angle relativement faible et dépendant de la durée qui sépare les excitations.

Il a pu être montré que cette technique, bien que ne comportant pas d'impulsion d'excitation d'écho de spin à 180°, provoque la renaissance de signaux de RMN composites formés d'échos de signaux de précession libre. Ces signaux renaissants peuvent être utilisés comme signaux de RMN mesurables. On a ainsi montré qu'il était possible de créer un état d'équilibre dynamique entre une aimantation longitudinale $M_z$ des moments magnétiques des particules et l'aimantation transversale $M_{xy}$ de ces moments magnétiques en choisissant une impulsion radiofréquence correspondant à un angle de basculement, dit angle de ERNST, dont la valeur est fonction de la répétitivité des impulsions d'excitation de la séquence et du temps de relaxation spin-réseau moyen des particules que l'on cherche à représenter.

En l'absence de toute application d'impulsions de gradient, le phénomène se produit simplement. Par contre, pour l'imagerie, il est nécessaire d'appliquer, au cours de chaque séquence, des impulsions de codage de l'espace en vue de différencier les contributions des différentes particules dans le signal de RMN. On a pu montrer que l'équilibre dynamique de l'aimantation transversale $M_{xy}$ est obtenu si on rephase l'aimantation transversale au moment de chaque impulsion. Le rephasage est obtenue en renversant le sens des gradients à l'origine du déphasage : en compensant en fin de chaque séquence les effets de déphasage dûs aux gradients codeurs de l'image. La réapparition du signal de RMN du fait de ce rephasage est appelé "écho de gradient". Cette notion de déphasage — rephasage ne concerne que les particules immobiles placées à différents endroits dans le champ magnétique de la machine.

Après avoir appliqué un certain nombre d'impulsions d'excitation, on peut considérer que le régime d'équilibre dynamique est établi. Dans ce régime on note une décroissance du signal de RMN après chaque impulsion et une remontée de ce signal avant chaque impulsion. On peut considérer que la décroissance est l'équivalent d'un signal de précession libre d'une séquence classique. On peut également considérer que la remontée est l'équivalent d'un signal d'écho de spin. La mesure du signal de RMN peut être obtenue en avançant la date de mesure de ce signal de remontée dans la séquence. Ceci peut être obtenu par application d'impulsions de gradients supplémentaires qui détruisent par déphasage la composante du signal de RMN liée au signal de précession libre. Ces impulsions de gradient supplémentaires ont donc pour effet d'une part de séparer les signaux de lecture selon leur origine : ceux provenant du signal de precession libre, ou ceux provenant du signal de remontée. Elles ont aussi pour effet d'autre part d'avancer dans la séquence d'excitation-lecture la période pendant laquelle la lecture est faite de manière à ce que cette lecture du signal de RMN ne se produise pas au moment où justement on applique l'excitation.

Dans l'invention on a mis à profit l'existence de procédés rapides de type SSFP pour produire des images de diffusion moléculaire apparente ou, en réitérant une fois de plus les séries d'excitations, des images de diffusion moléculaire vraie et de micro-circulation. En principe les procédés de type SSFP ne sont pas indiqués pour ces images car la sensibilisation du signal de RMN à l'effet de diffusion moléculaire passe par l'application d'impulsion de gradients diffusants fortes, c'est-à-dire d'amplitude et de durée élevées. Or dans une séquence SSFP, la durée d'application de ces impulsions est forcément courte puisque la séquence est elle même courte. Le principe de l'invention repose néanmoins sur la réitération d'une séquence de SSFP avec une force d'une impulsion de gradient diffusant destinée à éliminer la composante de précession libre, et à sensibiliser la séquence à la diffusion et aux microcirculations, différente dans une deuxième série de séquences que dans une première série. Par contre on garde pour les différentes séries de séquences des mêmes caractéristiques d'excitation-lecture (en particulier un temps de répétition qui est le même), et des mêmes caractéristiques d'imagerie (de préférence on recherche la représentation d'images comparables, avec une même définition, donc avec un même nombre de séquences dans les séries de séquences). On a pu montrer qu'un effet d'intégration de ces impulsions de ce gradient diffusant se produisait qui aboutit alors à une sensibilisation paradoxalement forte.

L'invention en conséquence a pour objet un procédé d'imagerie de mouvements intravoxel par RMN dans un corps, comportant les étapes suivantes :

– a) on plonge le corps à examiner dans un champ magnétique orientateur,

– b) on soumet le corps à une première série de séquences d'excitations électromagnétiques radiofréquences de type SSFP, en présence de gradients de champ magnétique de codage d'image,

– c) on mesure le signal de résonance magnétique émis en retour par le corps à l'issue de chacune des séquences de la première série et on en extrait les caractéristiques d'une première image dite normale,

– d) on soumet le corps à une deuxième série de séquences d'excitations électromagnétiques radiofréquences de type SSFP de mêmes caractéristiques que les séquences de la première série, en présence de gradients de champ magnétique de codage d'image et en présence de premiers gradients de champ magnétique de sensibilisation,

– e) on mesure le signal de résonance magnétique émis en retour par le corps à la fin de chacune des séquences de la deuxième série et on en extrait les caractéristiques d'une deuxième image dite sensibilisée,

– f) on compare les caractéristiques de la première image normale aux caractéristiques de la deuxième image sensibilisée, et on en déduit les caractéristiques d'une troisième image correspondant au mouvement intravoxels dans le corps.

L'invention sera mieux comprise à la lecture de la description qui suit et à l'examen des figures qui l'accompagnent. Celles ci ne sont données qu'à titre indicatif et nullement limitatif de l'invention. Les figures montrent:

– figure 1 : une machine pour la mise en oeuvre du procédé d'imagerie de l'invention ;

– figure 2a à 2c : des diagrammes temporels de signaux d'excitation, de RMN, et de gradient de champ utilisés dans le procédé de l'invention ;

– figure 3 : une représentation schématique de l'organisation des expérimentations à mener pour mettre en oeuvre une variante préférée du procédé de l'invention.

La figure 1 représente une machine de RMN pour la mise en oeuvre du procédé de l'invention. Cette machine comporte des moyens symbolisés par une bobine 1 pour soumettre un corps 2 à un champ magnétique important et constant $B_0$. Ce dispositif comporte encore des moyens générateurs 3 et bobines 4 pour soumettre le corps ainsi placé à des séquences d'excitation de type SSFP en présence de séquence de gradient de champ (figure 2b, figure 2c). Les bobines 4 représentent les bobines radiofréquences et les bobines de gradient de champ. La machine comporte encore des moyens de réception 5 reliés aux bobines 4 pour recevoir le signal de résonance magnétique, et des moyens 6 pour calculer et mémoriser une première image normale $I_1$ et une deuxième image sensibilisée $I_2$ relative à deux expérimentations imposées par des commandes, symbolisées $C_1$ et $C_2$, des moyens générateur 3. Dans des circuits de traitements 7 on compare point à point les images $I_1$ et $I_2$ en calculant le logarithme du rapport des valeurs représentatives des signaux de résonance magnétique attribuées à chaque point d'image (pixel) des images.

Le circuit de traitement 7 élabore alors une troisième image $I_3$ représentative des mouvements intravoxels dans laquelle deux régions 8 et 9 du corps 2, à l'endroit d'une coupe imagée, présentent une réponse en valeur de diffusion moléculaire et/ou de perfusion différente, alors qu'elles auraient présenté des réponses identiques en image de résonance magnétique classique. Ces images $I_1$ à $I_3$ peuvent être visualisées sur un dispositif de visualisation 50. Le processus de calcul des images $I_1$ ou $I_2$ est classique. Dans un exemple la méthode d'imagerie employée par les moyens 6 est une méthode 2 D, de préférence une méthode dite 2DFT. Cette méthode d'imagerie 2DFT permet actuellement d'obtenir la meilleure qualité d'image. Dans une méthode d'imagerie 2D, seul un plan de coupe est excité à la fois, au moyen d'excitations radiofréquences appliquées en présence d'un gradient dit de sélection. Ainsi, pour simplifier l'explication, dans la figure 1 le gradient de sélection peut être orienté selon l'axe Z pour sélectionner une coupe transverse, (selon un plan XY). Le principe de l'imagerie 2DFT (ou 3DFT) est de coder en phase les différents signaux à acquérir. Ceci est obtenu par une (ou des) impulsion, d'un gradient dit déphaseur, dont l'axe est perpendiculaire à un gradient de lecture dont la direction est constante. Par exemple, pour une coupe transverse, le gradient de lecture pourra être le gradient X et le gradient de déphasage pourra être le gradient Y. Par une double transformée de Fourrier spatiale l'image est reconstruite, d'où le nom de la méthode. Bien que le procédé de l'invention est ici décrit avec une méthode d'imagerie de type 2DFT il est néanmoins applicable à d'autres méthodes d'imagerie, notamment les méthodes de type 3DFT qui se déduisent de celle-ci par une généralisation.

Dans le cas de l'invention les excitations radiofréquences sont de type SSFP. Elles sont représentées sur la figure 2a. Celle-ci montre une représentation type des impulsions d'excitation et les signaux correspondants de RMN en réponse à ces excitations. Dans une méthode de type de SSFP l'équilibre dynamique de l'aimantation longitudinale $M_Z$ et de l'aimantation transverse $M_{XY}$ est obtenu pour des excitations E faisant basculer l'orientation des moments magnétiques des particules dans le corps d'une angle $\alpha$ prédéterminé par le temps de relaxation spin-réseau $T_1$ des particules du corps d'une part, et par le temps de répétition TR qui sépare les différentes excitations les unes des autres d'autre part. Si l'angle $\alpha$ est correctement ajusté, on note la présence de deux signaux S de RMN, un premier signal 10 de précession libre et un second signal 11 dit de remontée. Dans une séquence de signal 11 se présente juste avant l'application d'une impulsion d'excitation 12 d'une séquence suivante. Le signal 11 est plus faible que le signal 10 à cause des effets conjugués des inhomogénéités du champ orientateur $B_0$ d'une part, et des effets des différences de vitesse de précession dû au décalage chimique et à la relaxation spin-spin ($T_2$) d'autre part.

Les figures 2b et 2c montrent les particularités de la méthode de l'invention. Dans chaque séquence de durée TR de deux séries de séquences, une excitation 13 est appliquée en présence d'une impulsion 14 d'un gradient de codage de sélection de coupe. Une impulsion 14 de sélection est suivie classiquement d'une impulsion 15 de rephasage des signaux de RMN lié à un déphasage imposé par la durée de l'impulsion 14. Immédiatement après la sélection de la coupe, une impulsion 16 d'un gradient codeur de phase Y est appliqué dont la valeur varie d'une séquence à l'autre. Pour cette raison le gradient codeur de phase 16 est montré avec une flèche de variation en travers. Une impulsion 17 d'un gradient codeur de lecture est appliqué au moment où

on désire prélever le signal de RMN. Après la lecture, et de manière à ce qu'une impulsion d'excitation 18 suivante soit appliquée aux particules dans les mêmes conditions, chacune de ces impulsions 14 à 17 est compensée par des impulsions, sur les mêmes axes, de gradient respectivement 19 à 22. Si on agissait ainsi simplement la remontée 11 du signal RMN, et donc sa lecture, devraient se trouver juste avant l'application de l'excitation 18. Il est connu que par application d'une impulsion 23, appliquée sur l'axe de lecture préalablement à la lecture on peut provoquer, d'une part la dispersion de phase du signal de RMN lié au signal de précession libre, et d'autre part on peut faire avancer dans la séquence, à une date exploitable T, le moment où on peut efficacement mesurer un signal S de remontée.

Dans l'invention, figure 2c, on réitère avec les mêmes caractéristiques les excitations radiofréquences et les mesures au cours d'une deuxième série de séquences pendant lesquelles on augmente l'efficacité de l'impulsion de dispersion 23. Par exemple on impose une impulsion 24 de gradient supplémentaire sur l'axe de lecture d'intensité G et de durée d. Si on calcule, (figure 3) d'une manière classique une première image normale $I_1$ à l'issue des séries de séquences de la figure 2b, et si on calcule dans les mêmes conditions une deuxième image dite sensibilisée $I_2$ à l'issue des séquences représentées sur la figure 2c, on peut en comparant point à point les points d'image de ces images (en calculant le logarithme du rapport des luminosités affectées à chacun de ces points d'images) en déduire une troisième image $I_3$ représentative des mouvements intravoxels. On s'est alors rendu compte que cette impulsion de gradient supplémentaire G.d, qui a pour effet de réduire l'amplitude du signal $S_1$ de RMN au prorata des mouvements à l'intérieur des voxels, est, dans cette séquence de type SSFP, bien plus efficace qu'une impulsion équivalente (G.d) de gradient appliquée dans la méthode précédente à écho de spin. En effet pour obtenir les mêmes résultats, il est nécessaire, dans l'état de la technique citée, de choisir des durées d' des gradients diffusant bien plus grandes que celles qu'on peut choisir maintenant. En pratique les séquences à écho de spin utilisées dans l'état de la technique précité ont des temps de répétion (TR) de l'ordre de 500 à 1000 millisecondes. Tandis que la durée TR d'une séquence de type SSFP est de l'ordre de 100 millisecondes du maximum. Alors que les impulsions de gradient diffusantes, dispersives, susceptibles d'être appliquées dans de telles séquences devraient, à cause de leur durée, être dix fois moins efficaces, elles le sont en fait quatre fois plus. Dans l'invention on s'est rendu compte en maintenant les dates T auxquelles étaient effectuées les lectures des signaux de RMN résultant, que l'efficacité des impulsions 24 était paradoxalement bien plus grande.

On attribue la plus grande efficacité de l'impulsion 24, a priori plus faible que celle qu'on pourrait appliquer dans les mêmes conditions dans une séquence classique à échos de spin, à l'intégration de déphasage que subissent les signaux de RMN des moments magnétiques des particules dont les échos sont provoqués par la succession des excitations. En simplifiant l'explication, on peut admettre que le signal S mesuré dans une séquence de type SSFP est le résultat composite des contributions d'un certain nombre d'échos de signaux de précession libre. On peut ainsi montrer, si on choisit des instants particuliers d'application des excitations (de manière, par exemple, à ne faire basculer avec chaque excitation que les moments magnétiques que leur précession a amené à être en opposition de phase par rapport à un signal cohérent), que pour les particules fixes dans le corps l'effet de l'impulsion de gradient 24, comme celui de l'impulsion 23, s'inverse d'une fois sur l'autre et n'a en définitive que des effets compensés. Par contre pour les particules animées de mouvements dans le corps, d'une séquence à la suivante, la compensation des déphasages ne se produit pas. De sorte que leur contribution au signal de remontée se dispersent : le signal de remontée devient d'autant plus faible que ces particules animées de mouvements sont nombreuses.

Compte tenu du fait que les séquences de type SSFP délivrent des signaux de RMN dont le rapport signal à bruit est inférieur aux signaux exploitables à l'issue de séquences de type classique (parce que la durée de mesure est aussi plus faible), mais compte tenu que l'efficacité de l'impulsion 24 de gradient supplémentaire qui s'y trouve y est décuplée, les calculs de différenciation nécessaires pour aboutir à la troisième image $I_3$ représentative des mouvements à l'intérieur des éléments de volume conduisent alors à des résultats bien meilleurs.

La figure 3 représente un mode préféré pour la mise en oeuvre de l'invention. En effet, avec un temps de répétition de l'ordre de 100 millisecondes, chacunes des images normales $I_1$ et $I_2$ peut être acquise en une durée avoisinant la minute. Sachant alors que la patience des patients sous examen dans les machines de RMN n'est pas à ce stade exagérement sollicitée, on peut provoquer une troisième série de séquences, qui dure elle aussi une minute, en modifiant la valeur du gradient G et/ou la durée d de l'impulsion supplémentaire de gradient 24. Soient G' et d', les conditions d'acquisition d'une quatrième image $I_4$ dite, elle aussi, sensibilisée et dont les autres conditions d'acquisition (méthode d'imagerie) sont par ailleurs identiques à celle des images $I_1$ et $I_2$. Le signal de RMN reçu dans cette troisième série est appelé $S'_1$. En comparant, dans le circuit de comparaison 7 l'image $I_1$ à l'image $I_4$ de la même façon qu'on a comparé l'image $I_1$ à l'image $I_2$, on peut produire une deuxième image $I_5$ des mouvements à l'intérieur des voxels. En principe cette image permet également de différencier deux régions 8 et 9 du corps, à l'endroit de la coupe imagée, présentant entres elles des caractéristiques de mouvement intravoxel différentes. En comparant ensuite, point d'image par point d'image, la troisième image $I_3$ à la cinquième $I_5$, on peut calculer une sixième image $I_6$ représentative des caractéristiques vraies de diffusion moléculaire à l'intérieur de chacun des voxels excités d'une part et/ou une septième image $I_7$ représentative de la perfusion à l'intérieur des tissus étudiés. Cette deuxième comparaison peut revenir, comme décrit dans l'état de la technique précité, à trouver la solution d'un système de deux équations à deux inconnues. En effet on peut admettre que les deux coefficients apparents de diffusion moléculaire ADC et ADC' (obtenus point par point respectivement dans chacune des troisième et cinquième images peuvent s'écrire :

$$ADC = D + \left\{ Log\left[ \left( (1-f) + f F_0 \right) / \left( (1-f) + f F_1 \right) \right] \right\} / (b_1 - b_0)$$

$$ADC' = D + \left\{ Log\left[ \left( (1-f) + f F_0 \right) / \left( (1-f) + f F'_1 \right) \right] \right\} / (b'_1 - b_0)$$

Dans cette expression D est le coefficient de diffusion moléculaire vrai à l'intérieur d'un voxel dans le corps, f est la fraction volumique de ce voxel occupé par un fluide (le sang) circulant dans ce voxel $F_0$ et $F_1$ (ou $F'_1$) sont des facteurs d'atténuation dus aux microcirculations et relatifs aux séquences, respectivement non diffusantes et diffusantes, dans lesquelles on mesure les signaux $S_0$ et $S_1$ (ou $S'_1$), et où $b_0$, et $b_1$ (ou $b'_1$) sont des facteurs dépendant de la séquence de gradient utilisé. Dans la demande de brevet précitée on a indiqué comment calculer ces facteurs $F_0$, $F_1$ et $F'_1$. Notamment on a indiqué que $F_0$ était sensiblement égal à 1 et avait donc un effet négligeable pendant la séquence classique : ici les séquences représentées par la figure 2b. Et notamment, si les gradients ajoutés pour l'élaboration de $S_1$ et $S'_1$ sont suffisamment efficaces, on peut considérer que $F_1$ et $F'_1$ valent sensiblement 0. Ceci simplifie notablement les calculs où les expressions de ADC et ADC' deviennent :

$$ADC = D - (Log\ (1-f)) / (b_1 - b_0)$$

$$ADC' = D - (Log\ (1-f)) / (b'_1 - b_0)$$

Ces dernières formulations de ADC et ADC' comportent en fait deux inconnues D et f. On peut trouver ces deux inconnues en résolvant le système d'équation ainsi constitué. On cherche D et Log(1-f). Puis, connaissant Log(1-f) on trouve f. La première image $I_3$ est représentative des coefficient ADC, la seconde image $I_5$ est représentative des coefficients ADC'. Connaissant $b_1$ et $b'_1$ différents pour le calcul des images $I_2$ et $I_4$, on peut résoudre ce système. En pratique trois séquences sont donc nécessaires pour séparer les informations de diffusion vraie D et les informations de perfusion f en chaque élément de volume. Cette comparaison (solution de système d'équation) peut aussi être exécutée par les moyens de comparaison 7 qui, d'une manière préférée, comportent un processeur de traitement classique.

En partant du fait que, dans les séquences sensiblilisées, $F_1$ et $F'_1$ sont nuls, on peut écrire :

$$D = \left\{ Log\ (S_1 / S'_1) \right\} / (b'_1 - b_1)$$

Ceci permet de déterminer la sixième image de diffusion pure par comparaison directe des deuxième et quatrième images sensibilisées. De la comparaison de cette sixième image, obtenue directement, à la troisième image représentative des mouvements intra-voxel on peut déterminer ensuite la septième image de perfusion pure. La figure 4 illustre ce processus.

## Revendications

1. Procédé d'imagerie de mouvement intra-voxel par RMN dans un corps comportant les étapes suivantes:
– a) on plonge (1) le corps (2) à examiner dans un champ magnétique orientateur ($B_0$),
– b) on soumet (3,4) le corps à une première ($C_1$) série de séquences d'excitations électromagnétiques radiofréquences de type SSFP, en présence de gradients (14-23) de champ magnétique de codage d'image,

– c) on mesure (5) le signal de résonance magnétique émis en retour par le corps à l'issue de chacune des séquences de la première série et on en extrait (6) les caractéristiques d'une première image ($I_1$) dite normale

– d) on soumet le corps à une deuxième ($C_2$) série de séquences d'excitations électromagnétiques radiofréquences de type SSFP de mêmes caractéristiques que les séquences de la première série, en présence de gradients de champ magnétique de codage, et en présence de premiers (24) gradients de champ magnétique de sensibilisation,

– e) on mesure (5) le signal de résonance magnétique émis en retour par le corps à l'issue de chacune des séquences de la deuxième série et on en extrait (6) les caractéristiques d'une deuxième image ($I_2$) dite sensibilisée,

– f) on compare (7) les caractéristiques de la première image normale aux caractéristiques de la deuxième image sensibilisée, et on déduit (8,9) les caractéristiques d'une troisième image correspondant aux mouvements intravoxel dans le corps.

2. Procédé selon la revendication 1 caractérisé en ce que :

– g) on rétière, pour une troisième série de séquences, les étapes d), e), f), en exécutant les séquences en présence de deuxièmes gradients (G', d') de champ magnétique de sensibilisation, différents des premiers gradients de champ magnétique de sensibilisation, pour obtenir les caractéristiques d'une quatrième ($I_4$) image dite aussi sensibilisée,

– h) on compare (7) les caractéristiques de la première ($I_1$) image normale aux caractéristiques de la quatrième ($I_4$) image sensibilisée et on en déduit les caractéristiques d'une cinquième ($I_5$) image correspondant aux mouvements intravoxel dans le corps,

– i) on compare (7) les caractéristiques de la troisième image aux caractéristiques de la cinquième image pour en déduire une sixième ($I_6$) image de diffusion moléculaire (D) et/ou une septième ($I_7$) image de perfusion (f) d'un liquide dans le corps.

3. Procédé selon l'une quelconque des revendications 1 ou 2 caractérisé en ce qu'on visualise (50) les images obtenues.

## Patentansprüche

1. NMR-Abbildungsverfahren für intravoxelle Bewegungen in einem Körper, mit den folgenden Schritten :

– a) Eintauchen (1) des zu untersuchenden Körpers (2) in ein gerichtetes Magnetfeld ($B_0$),

– b) Unterwerfen (3, 4) des Körpers unter eine erste ($C_1$) Reihe von elektromagnetischen, hochfrequenten Anregungsfolgen vom SSFP-Typ bei Vorliegen von Gradienten (14-23) des Bildkodierungs-Magnetfeldes,

– c) Messen (5) des magnetischen Resonanzsignals, das bei der Ausgabe einer jeden der Folgen der ersten Reihe vom Körper zurückgesandt wird, und Aussondern (6) der Eigenschaften eines ersten Bildes ($I_1$), das Normalbild genannt wird,

– d) Unterwerfen des Körpers unter eine zweite ($C_2$) Reihe von Folgen von hochfrequenten, elektromagnetischen Anregungen vom SSFP-Typ mit den gleichen Eigenschaften wie die Folgen der ersten Reihe bei Vorliegen von Gradienten des Kodierungs-Magnetfeldes und bei Vorliegen von ersten (24) Gradienten eines Sensibilisierungs-Magnetfeldes,

– e) Messen (5) des magnetischen Resonanzsignals, das bei Ausgabe einer jeden der Folgen der zweiten Reihe vom Körper zurückgesandt wird, und Aussondern (6) der Eigenschaften eines zweiten Bildes ($I_2$), das sensibilisiertes Bild genannt wird,

– f) Vergleichen (7) der Eigenschaften des ersten Normalbildes mit den Eigenschaften des zweiten sensibilisierten Bildes und Ableiten (8, 9) der Eigenschaften eines dritten Bildes, das den intravoxellen Bewegungen im Körper entspricht.

2. Verfahren gemäß Anspruch 1, dadurch gekennzeichnet, daß

– g) die Schritte d), e), f) für eine dritte Reihe von Folgen wiederholt werden, indem die Folgen bei Vorliegen von zweiten Gradienten (G', d') des Sensibilisierungs- Magnetfeldes, die von den ersten Gradienten des Sensibilisierungs-Magnetfeldes verschieden sind, ausgeführt werden, um die Eigenschaften eines vierten ($I_4$) Bildes, das ebenfalls sensibilisiertes Bild genannt wird, zu erhalten,

– h) Vergleichen (7) der Eigenschaften des ersten ($I_1$) normalen Bildes mit den Eigenschaften des vierten ($I_4$) sensibilisierten Bildes und Ableiten der Eigenschaften eines fünften ($I_5$) Bildes, das den intravoxellen Bewegungen im Körper entspricht,

– i) Vergleichen (7) der Eigenschaften des dritten Bildes mit den Eigenschaften des fünften Bildes, um daraus ein sechstes ($I_6$) Bild der molekularen Diffusion (D) und/oder ein siebtes ($I_7$) Bild der Perfusion (f) einer Flüssigkeit im Körper abzuleiten.

3. Verfahren gemäß einem der Ansprüche 1 oder 2, dadurch gekennzeichnet, daß die erhaltenen Bilder sichtbar (50) gemacht werden.

## Claims

1. A method of producing an image of the intravoxel movement by NMR in a body comprising the following stages :

– a) plunging (1) the body (2) to be examined into an orientating magnetic field ($B_0$),

– b) subjecting (3 and 4) the body to a first ($C_1$) series of radiofrequency electromagnetic excitations of the SSFP type in the presence of gradients (14 through 23) of image encoding magnetic field,

– c) measuring (5) the magnetic resonance signal emitted in return by the body at the end of each of the sequences of the first series and extracting (6) the characteristics of a first image ($I_1$) termed the normal image,

– d) submitting the body to a second ($C_2$) series of radiofrequency electromagnetic excitations of the SSFP type with the same characteristics as the first series in the presence of gradients of image encoding magnetic field and in the presence of first (24) gradients of an image encoding magnetic sensitizing field,

– e) measuring (5) the magnetic resonance a signal emitted by the body at the end of each of the sequences of the second series and extracting (6) the characteristics of a second image ($I_2$) termed the sensitized one,

– f) comparing (7) the characteristics of the first normal image with the characteristics of the second sensitized image and deducing (8 and 9) the characteristics of a third image corresponding to the intravoxel movements in the body.

2. The method as claimed in claim 1, characterized by

– g) the reiteration, for a third series of sequences, the stages d), e) and f), while performing the sequences in the presence of the second sensitizing magnetic field gradients (G'and d'), different to the first sensitizing magnetic field gradients, in order to produce the characteristics of a fourth image ($I_4$), also termed a sensitized one,

– h) comparison (7) of the characteristics of the first normal image ($I_1$) with the characteristics of the fourth sensitized image ($I_4$) and deduction of the characteristics of a fifth image ($I_5$) corresponding to the intravoxel movements in the body,

– i) and comparison (7) of the characteristics of the third image with the characteristics of the fifth image in order to deduce a sixth image ($I_6$) of molecular diffusion (D) and/or a seventh image ($I_7$) of perfusion (f) of a liquid in the body.

3. The method as claimed in claim 1 or claim 2, characterized in that the images produced are made visible (50).

FIG.1

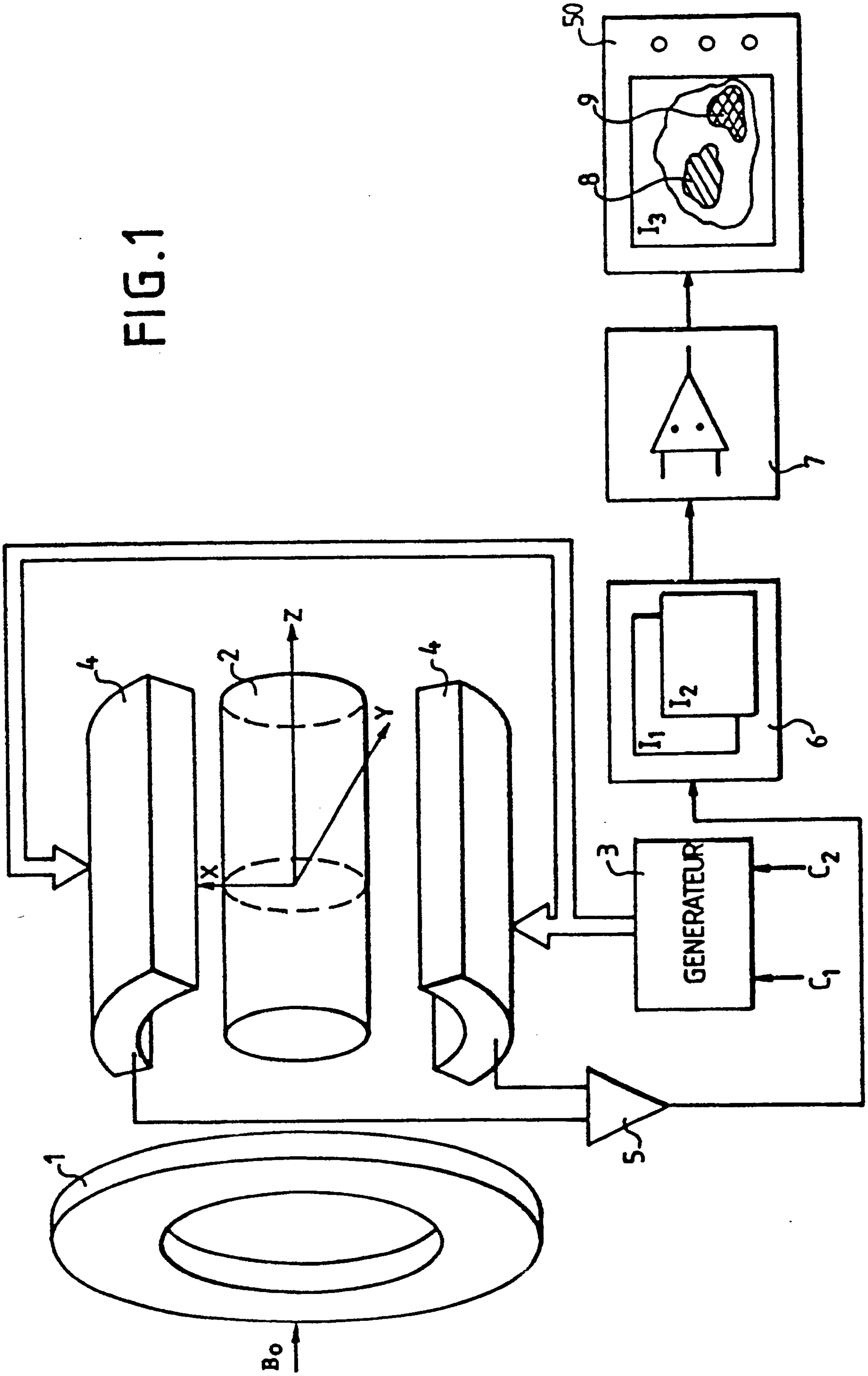

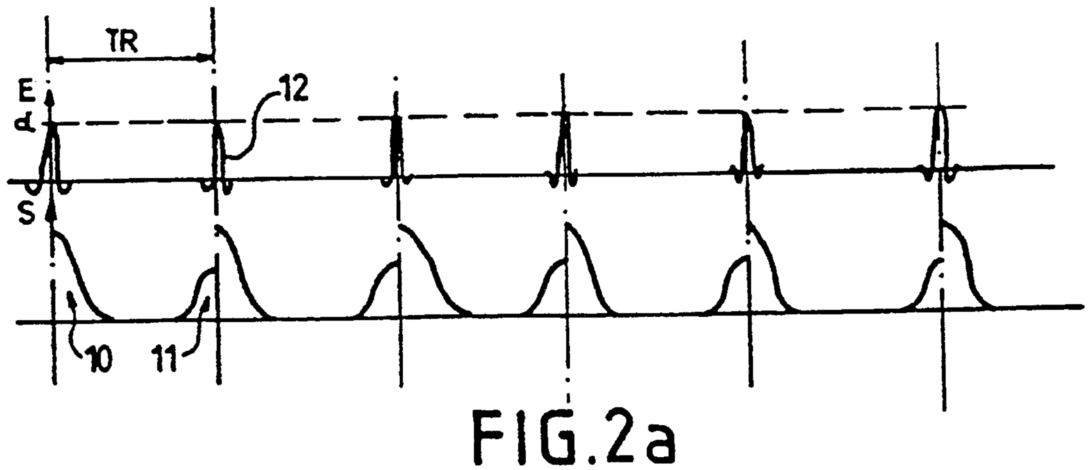


FIG.2a

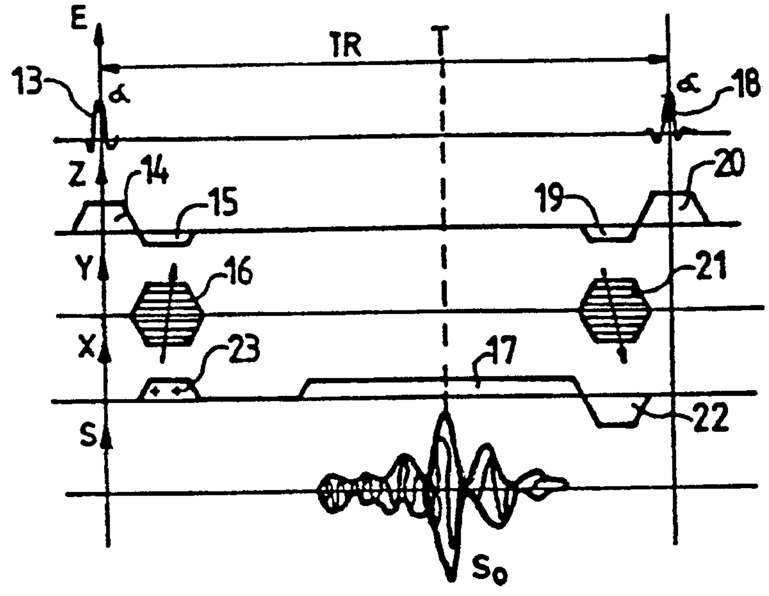


FIG.2b

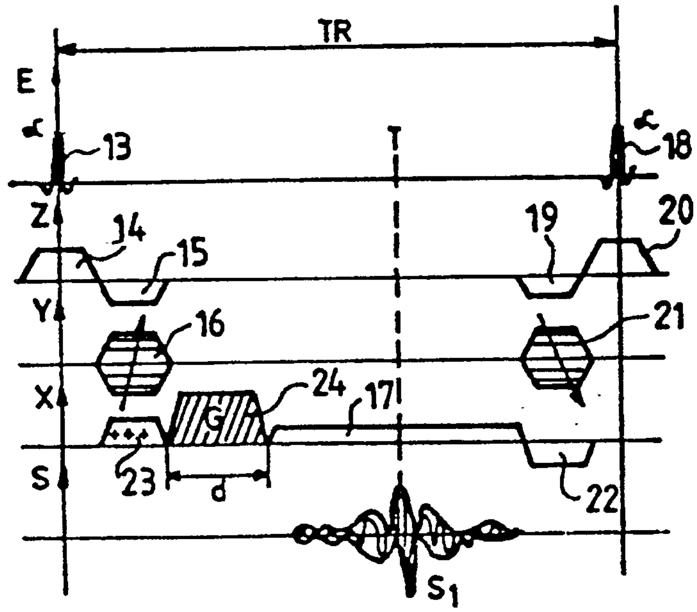


FIG.2c

FIG.3

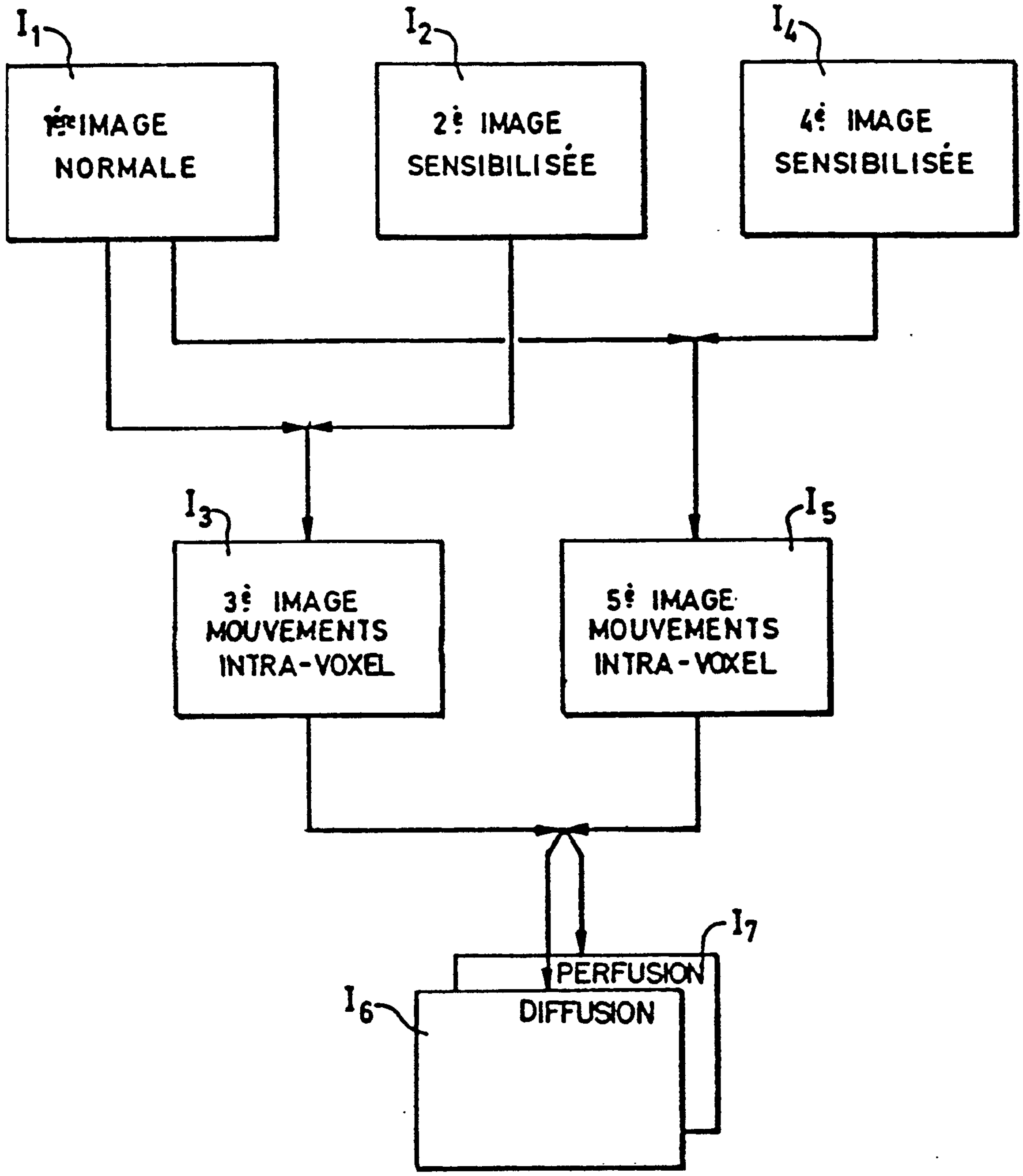
I1
1re IMAGE
NORMALE
I2
2e IMAGE
SENSIBILISÉE
I4
4e IMAGE
SENSIBILISÉE
I3
3e IMAGE
MOUVEMENTS
INTRA-VOXEL
I5
5e IMAGE
MOUVEMENTS
INTRA-VOXEL
I7
PERFUSION
I6
DIFFUSION

FIG.4

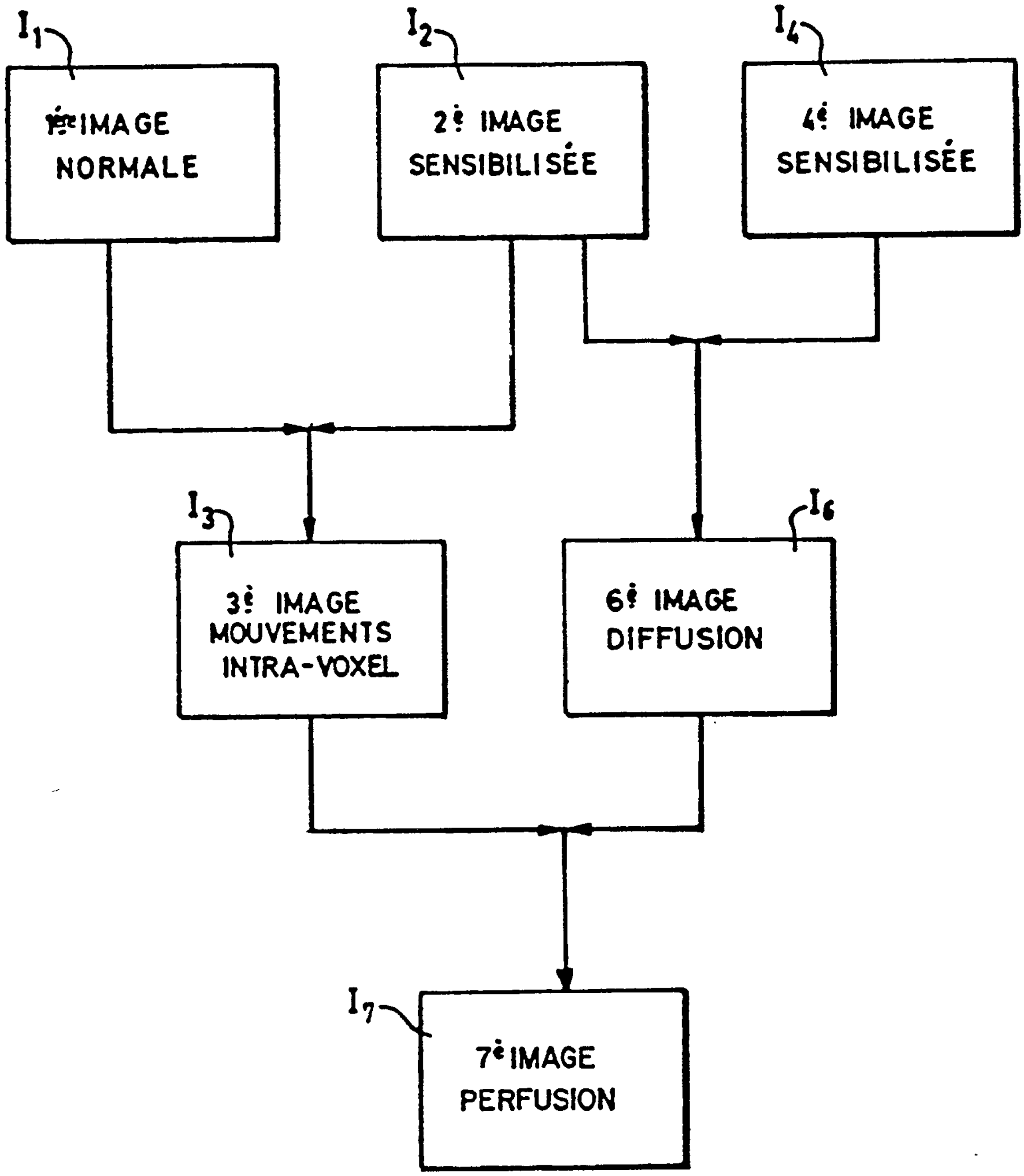
I1
1re IMAGE NORMALE
I2
2e IMAGE SENSIBILISÉE
I4
4e IMAGE SENSIBILISÉE
I3
3e IMAGE MOUVEMENTS INTRA-VOXEL
I6
6e IMAGE DIFFUSION
I7
7e IMAGE PERFUSION